# EUROPEAN PATENT SPECIFICATION

(11) **EP 2 054 999 B1**
(45) Date of publication and mention of the grant of the patent: **08.06.2011**
(21) Application number: 07826004.9
(22) Date of filing: 08.08.2007
(51) Int. Cl.: H03D 7/14

(54) **SIGNAL PROCESSOR COMPRISING A FREQUENCY CONVERTER**
SIGNALPROZESSOR MIT EINEM FREQUENZUMRICHTER
PROCESSEUR DE SIGNAL COMPORTANT UN CONVERTISSEUR DE FRÉQUENCE

(30) Priority: 09.08.2006 EP 06118655
(43) Date of publication of application: 06.05.2009
(73) Proprietor: ST-Ericsson SA, 1228 Genève (CH)
(72) Inventor: VAN ZEIJL, Paulus, T., M., NL-5656 AG Eindhoven (NL); DE JONG, Gerben, W., NL-5656 AG Eindhoven (NL); JEURISSEN, Dennis, NL-5656 AG Eindhoven (NL)
(74) Representative: Bird, William Edward
(86) International application number: PCT/IB2007/053137
(87) International publication number: WO 2008/018033

(56) References cited:
- US-A- 4 590 433
- US-A1- 2002 030 529
- US-A1- 2005 009 495
- US-B1- 6 801 585

## Description

### FIELD OF THE INVENTION

An aspect of the invention relates to a signal processor that comprises a frequency converter. The signal processor may be, for example, a radiofrequency receiver or a radiofrequency transmitter, or a combination of both, which is at least partially implemented as an integrated circuit. Another aspect of the invention relates to a communication apparatus, which is capable of communicating in accordance with, for example, one or more communication standards known under the following acronyms: GSM, EDGE, DCS 1800, CDMA, WLAN, and BT-EDR.

### BACKGROUND ART

A frequency converter is an entity that frequency shifts an input spectrum so as to obtain an output spectrum that is a frequency-shifted version of the input spectrum. There are many types of signal processors that comprise a frequency converter. For example, a radiofrequency receiver typically comprises a frequency converter for frequency shifting a received radiofrequency spectrum, which comprises various channels, so as to obtain a so-called intermediate frequency spectrum in which one particular channel is selected. Conversely, a radiofrequency transmitter typically comprises a frequency converter for frequency shifting a baseband signal, which comprises information to be transmitted, so as to obtain a radiofrequency signal, which may be applied to an antenna via, for example, a radiofrequency power amplifier. There are numerous types of measurement apparatuses that comprise one or more frequency converters.

A frequency converter typically comprises a so-called local oscillator and a mixer. The local oscillator provides a mixer driver signal, which is a periodical signal having a fundamental frequency. The mixer multiplies an input signal, which comprises an input spectrum, by the mixer driver signal. Accordingly, the mixer provides an output signal that comprises a frequency-shifted version of the input spectrum. The fundamental frequency of the mixer driver signal generally determines a desired frequency shift.

A frequency converter may be of the multiphase type. A multiphase frequency converter comprises various mixers. The local oscillator provides various mixer driver signals: at least one mixer driver signal for each mixer. The respective mixer driver signals have a particular phase relationship with respect to each other. Many integrated receivers comprise a quadrature frequency converter, which typically comprises two mixers: a so-called in-phase mixer and a so-called quadrature mixer. The respective mixer driver signals for these mixers have a 90° phase relationship with respect to each other.

Many mixers comprise at least one pair of switches. A pair of switches has a common switch node on which an input signal is present. One switch is coupled between the common switch node and a non-inverting node of an output circuit. The other switch is coupled between the common switch node and an inverting node of the output circuit. The one or the other switch is conductive depending on whether the mixer driver signal has a high value or a low value, respectively, or vice versa. Accordingly, the pair of switches alternately applies the input signal to the non-inverting node and the inverting node of the output circuit. This produces an output signal that corresponds with the input signal multiplied by a square wave signal whose frequency is the fundamental frequency of the mixer driver signal that controls the pair of switches. A so-called Gilbert cell mixer comprises a double pair of switches that receives a differential input signal, one pair of switches for each component of the differential input signal.

In practice, a mixer exhibits a nonlinear behavior to a certain extent, which results in spurious signals. There are various different Figures of merit for the nonlinear behavior of a mixer. The second-order input-referred intercept point (IIP2) is an important Figure of merit, in particular for integrated mixers, which are implemented in CMOS technology. Such mixers may form part of integrated receivers for modem communication standards, such as, for example, the communication standards known under the following acronyms: GSM, EDGE, DCS1800, CDMA, WLAN, and BT-EDR. Such integrated receivers typically require to have an IIP2 in the order of 40 to 50 dBm (dBm is an acronym for the power ratio in decibel of the measured power referenced to one milliWatt).

US patent 4,590,433 describes a Gilbert cell mixer that comprises four switching transistors, which constitute a double pair of switches. The switching transistors are all fully conductive prior to any transition in which two switching transistors are rendered non-conductive, one in each pair of switches. Fig. 5a of the aforementioned US patent illustrates a pair of mixer driver signals, which the switching transistors receive. Fig. 5b illustrates a voltage at commonly connected emitters of the one and the other pair of switching transistors. This voltage never drops below a level corresponding with a power supply voltage (V_{CC}) from which a forward base-to-emitter voltage (V_{F}) is subtracted.

### SUMMARY OF THE INVENTION

It is an object of the invention to allow an improvement in signal processing, which involves a frequency conversion, in particular by allowing a relatively high second-order input-referred intercept point. The independent claims define various aspects of the invention. The dependent claims define additional features for implementing the invention to advantage.

The invention takes the following points into consideration. In a mixer that comprises a pair of switches as described hereinbefore, a second harmonic of the mixer driver signal will generally be present at the common switch node. The presence of the second harmonic adversely affects the second-order input-referred intercept point (IIP2). In theory, the second harmonic of the mixer driver signal is not present at the common switch node in the Gilbert cell mixer that the aforementioned US patent describes. However, this Gilbert cell mixer has a relatively poor performance in terms of noise. This is because both switching transistors in a pair are conductive during an interval of time before one of the switching transistors is rendered non-conductive. The Gilbert cell mixer inherently has a noisy behavior during such an interval of time, when both switching transistors are conductive.

In accordance with the invention, a signal processor includes a frequency converter of the multiphase type, which has the following characteristics. A first phase mixer has a pair of switches with a common switch node. A second phase mixer also has a pair of switches with a common switch node. The common switch node of the pair of switches in the first phase mixer corresponds with the common switch node of the pair of switches in the second phase mixer. Accordingly, the pair of switches in the first phase mixer and the pair of switches in the second phase mixer have a joint common switch node. A local oscillator generates an individual mixer driver signal for each switch in the aforementioned pairs. Each individual mixer driver signal comprises periodically occurring pulses, which are phase shifted with respect to the periodically occurring pulses in the other individual mixer driver signals.

Accordingly, at least four switches are coupled to the joint common switch node: two switches that form a pair in the first phase mixer, and two switches that form a pair in the second phase mixer. Each switch receives periodically occurring pulses, which are phase shifted with respect to the periodically occurring pulses that the other switches receive. As a result, the joint common switch node experiences, as it were, at least four mutually phase-shifted pulses during a period with which pulses periodically occur in each individual mixer driver signal. This period is the inverse of the fundamental frequency of the individual mixer driver signals. Accordingly, a fourth harmonic frequency component, or a higher harmonic frequency component, may therefore occur on the joint common switch node, instead of a second harmonic frequency component, which typically occurs on a common switch node in a conventional frequency converter. Since a second harmonic frequency component does not substantially occur on the joint common switch node, the frequency converter in accordance with the invention has a relatively high second-order input-referred intercept point.

Another advantage of the invention relates to the following aspects. A signal processor that comprises a quadrature frequency converter typically has an in-phase signal processing branch, which includes the first phase mixer, and a quadrature signal processing branch, which includes the second phase mixer. In general, it is desirable that these respective signal processing branches have an identical gain. Any gain mismatch between the first phase mixer and the second phase mixer may introduce distortion or render the signal processor more sensitive to spurious signals, or both.

In practice, the first phase mixer and the second phase mixer have respective conversion gains that differ to a certain extent due to, for example, tolerances, environmental changes, and aging. This is particularly true for conventional quadrature frequency converters that comprise a pair of input amplifiers: one input amplifier for the in-phase mixer and another input amplifier for the quadrature mixer. In practice, there will be a gain mismatch between these respective input amplifiers.

The invention allows implementations in which a common input amplifier applies an input signal to the joint common switch node of the pair of switches in first phase mixer and the pair of switches of the second phase. That is, the first phase mixer and the second phase mixer share, as it were, one and the same input amplifier. Accordingly, the invention eliminates a source of gain mismatch with respect to conventional quadrature frequency converters. As a result, the invention allows a better gain match between the in-phase signal processing branch and the quadrature signal processing branch, which improves signal quality.

An implementation of the invention advantageously comprises one or more of following additional features, which are described in separate paragraphs that correspond with individual dependent claims.

The local oscillator generates the individual mixer driver signals preferably so that there is substantially no overlap between the periodically occurring pulses in the individual mixer driver signals. This allows a relatively low noise Figure.

The local oscillator generates the individual mixer driver signals preferably so that each individual mixer driver signal has a duty cycle that is substantially 25%. This allows a quadrature frequency converter that has a relatively high second-order input-referred intercept point combined with a relatively low noise Figure.

The first phase mixer preferably comprises a further pair of switches. The second phase mixer also preferably comprises a further pair of switches. The further pair of switches of the first phase mixer and the further pair of switches of the second phase mixer have a joint common switch node. These features allow implementations with a differential structure, which further contributes to a relatively high second-order input-referred intercept point.

The switches are preferably in the form of field effect transistors. This allows low-cost integrated circuit implementations, which are based on CMOS technology.

A common input stage preferably applies a signal current to the joint common switch node. This feature further contributes to a relatively low noise Figure.

The local oscillator preferably comprises a double-frequency oscillator, which provides a double-frequency oscillator signal, a frequency divider, and a logic gate circuit. The frequency divider provides an in-phase oscillator signal and a quadrature oscillator signal on the basis of the double-frequency oscillator signal. The logic gate circuit generates the individual mixer driver signals, which are preferably mutually non-overlapping, on the basis of the in-phase oscillator signal and the quadrature oscillator signal. These features allow low-cost implementations.

A detailed description with reference to drawings illustrates the invention summarized hereinbefore, as well as the additional features.

### BRIEF DESCRIPTION OF THE DRAWINGS

Fig. 1 is a block diagram that illustrates a communication apparatus.
Fig. 2 is a circuit diagram that illustrates a dual mixer, which forms part of the communication apparatus.
Fig. 3 is a signal diagram that illustrates a set of mixer driver signals, which the dual mixer receives.
Fig. 4 is a block diagram that illustrates a local oscillator, which provides the set of mixer driver signals illustrated in Fig. 3.

### DETAILED DESCRIPTION

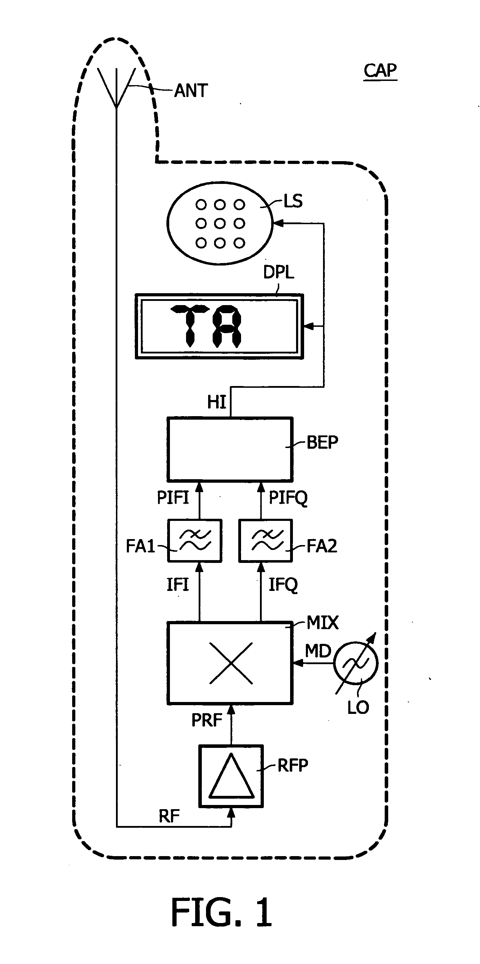

Fig. 1 illustrates a communication apparatus CAP, which may be in the form of, for example, a cellular phone. The communication apparatus CAP comprises a loudspeaker LS and a display device DPL, which constitute human interface devices. The communication apparatus CAP further comprises various functional entities that constitute a receiver, which is coupled between an antenna ANT and the human interface devices. These functional entities include a radiofrequency processor RFP, a dual mixer MIX and a local oscillator LO, which constitute a frequency converter of the quadrature type, two intermediate frequency processing circuits FA1, FA2, and a backend processor BEP. The aforementioned functional entities may be implemented, for example, as a single integrated circuit. As another example of implementation, there may be various different integrated circuits, each of which comprises one or more functional entities. The communication apparatus CAP may further comprise a controller, which is typically in the form of a suitably programmed processor, as well as various other functional entities, which, for example, constitute a transmitter. Fig. 1 does not illustrate these functional entities for reasons of simplicity.

The receiver within communication apparatus CAP basically operates as follows. The antenna ANT picks up a radiofrequency signal RF, which has a given frequency spectrum. The radiofrequency processor RFP filters and amplifies the radiofrequency signal RF. Accordingly, the radiofrequency processor RFP provides a processed radiofrequency signal RFP, which is a filtered and amplified version of the radiofrequency signal RF that the antenna ANT picks up. The dual mixer MIX effectively multiplies the processed radiofrequency signal RFP by a set of mixer driver signals MD, which the local oscillator LO provides. The dual mixer MIX provides an in-phase intermediate frequency signal IFI and a quadrature intermediate frequency signal IFQ. Each of these intermediate frequency signals IFI, IFQ has a frequency spectrum, which is a frequency-shifted version of the frequency spectrum of the radiofrequency signal RF.

The two intermediate frequency processing circuits FA1, FA2 filter and amplify the in-phase intermediate frequency signal IFI and the quadrature intermediate frequency signal IFQ, respectively. Accordingly, the two intermediate frequency processing circuits FA1, FA2 provide a processed in-phase intermediate frequency signal PIFI and a processed quadrature intermediate frequency signal PIFQ, respectively. These processed intermediate frequency signals constitute a frequency-shifted version of a desired channel within the radiofrequency spectrum received. Spurious components, which might otherwise cause interference, are suppressed to certain extent. The backend processor BEP derives human interface signals HI from the processed intermediate frequency signals. To that end, the backend processor BEP may carry out various operations, such as, for example, channel filtering, demodulation, and, in the case of digital signals, channel decoding, error correction, and baseband decoding.

The receiver within the communication apparatus CAP has a performance that depends to relatively a large extent on the dual mixer MIX and the local oscillator LO, which constitute the frequency converter. Two Figures of merit are of particular importance: noise Figure and second-order input-referred intercept point. A relatively low noise Figure allows the receiver to have a good sensitivity: the human interface signals are of satisfactory quality even if the radiofrequency signal RF is relatively weak. A relatively high second-order input-referred intercept point allows the receiver to be immune against relatively strong out-of-channel signals: the human interface signals are of satisfactory quality even in the presence of relatively strong signals outside the desired channel. It should be noted that relatively strong out-of-channel signals may produce spurious signals within the desired channel, in particular when the second-order input-referred intercept point is relatively low. The two intermediate frequency processing circuits FA1, FA2 cannot suppress these spurious signals. It is therefore important that the frequency converter has a relatively high second-order input-referred intercept point.

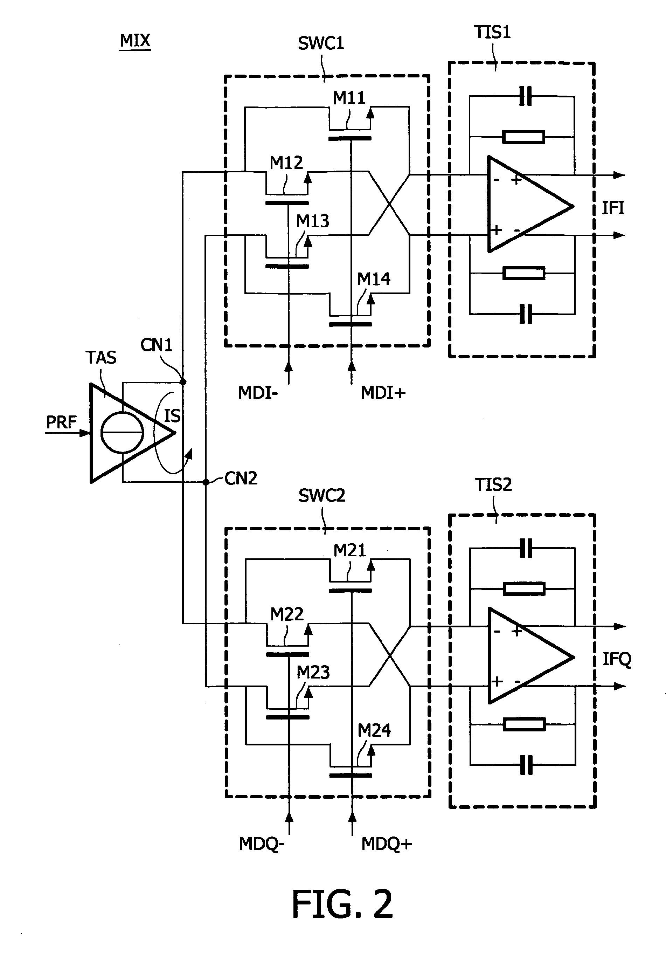

Fig. 2 illustrates the dual mixer MIX within the communication apparatus CAP illustrated in Fig. 1. The dual mixer MIX has a common transadmittance stage TAS, which receives the processed radiofrequency signal RFP. The dual mixer MIX further comprises two switch cells SWC1, SWC2 and two transimpedance stages TAS1, TAS2, each having a non-inverting input "+" and an inverting input "-". Switch cell SWC1 and transimpedance stage TIS 1 constitute an in-phase mixer, which provides the in-phase intermediate frequency signal IFI. Switch cell SWC2 and transimpedance stage TIS2 constitute a quadrature mixer, which provides the quadrature intermediate frequency signal IFQ.

Switch cell SWC1 comprises four transistors M11, .., M14, which may be of the field effect type. Transistors M11, M12 constitute a switch pair. Transistors M13, M 14 constitute another switch pair. Switch cell SWC2, which is of similar construction, also comprises four transistors M21, .., M24. Transistors M21, M22 constitute a switch pair. Transistors M23, M24 constitute another switch pair. Each respective switch pair has a common switch node.

The common switch node of the switch pair that is formed by transistors M11, M 12 in switch cell SWC1, corresponds with the common switch node of the switch pair that is formed by transistors M21, M22 in switch cell SWC2. Accordingly, the aforementioned switch pairs, M11, M12 and M21, M22, have a joint common switch node CN1. Similarly, the common switch node of the switch pair that is formed by transistors M13, M14 in switch cell SWC1, corresponds with the common switch node of the switch pair that is formed by transistors M23, M24 in switch cell SWC2. Accordingly, the aforementioned switch pairs, M13, M 14 and M23, M24, also have a joint common switch node CN2.

Switch cell SWC1 receives a pair of in-phase mixer driver signals: a non-inverting in-phase mixer driver signal MDI+ and an inverting in-phase mixer driver signal MDI-. Switch cell SWC2 receives a pair of quadrature mixer driver signals: a non-inverting quadrature mixer driver signal MDQ+ and an inverting quadrature mixer driver signal MDQ-The set of mixer driver signals MD illustrated in Fig. 1, thus comprises the aforementioned pair of in-phase mixer driver signals MDI+, MDI- and the aforementioned pair of quadrature mixer driver signals MDQ+, MDQ-.

The dual mixer MIX basically operates as follows. The common transadmittance stage TAS converts the processed radiofrequency signal RFP into a differential signal current IS. At any given instant, either transimpedance stage TIS 1 or transimpedance stage TIS2 receives the differential signal current IS in inverted form or in a non-inverted form. That is, at any given instant, only one of the two switch cells SWC1, SWC2 constitutes a current-passing circuit, which allows the differential signal current IS to reach the transimpedance stage that is coupled to the switch cell concerned. The other switch cell constitutes a current-blocking circuit, which prevents the differential signal current IS from reaching the transimpedance stage that is coupled to the switch cell concerned. The switch cell that constitutes the current-passing circuit either applies the differential signal current IS to the transimpedance stage concerned in a non-inverted form or in an inverted form.

The set of mixer driver signals MD alternately cause switch cell SWC1 and switch cell SWC2 to momentarily constitute the current-passing circuit. Moreover, the set of mixer driver signals MD alternately cause switch cell SWC1 to apply the differential signal current IS to transimpedance stage TIS in a non-inverted form and in an inverted form, when switch cell SWC1 momentarily constitutes the current passing circuit during an interval of time and a subsequent interval of time, respectively. The same applies to switch cell SWC2, which alternately applies the differential signal current IS to transimpedance stage TIS in a non-inverted form during an interval of time when switch cell SWC2 momentarily constitutes the current-passing circuit, and in an inverted form during a subsequent interval of time when switch cell SWC2 momentarily constitutes the current-passing circuit.

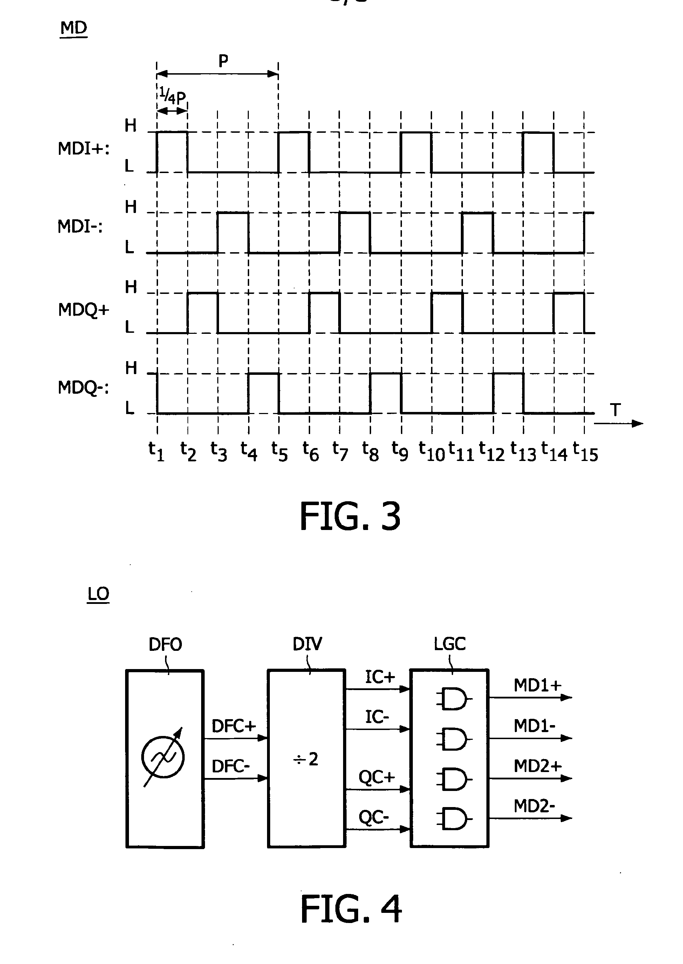

Fig. 3 illustrates the set of mixer driver signals MD. Fig. 3 is a composite graph that comprises four signal diagrams with a common horizontal axis, which represents time T. An upper signal diagram illustrates the non-inverting in-phase mixer driver signal MDI+. An upper-middle signal diagram illustrates the inverting in-phase mixer driver signal MDI-. A lower-middle signal diagram and a lower signal diagram illustrate the non-inverting quadrature mixer driver signal MDQ+ and the inverting quadrature mixer driver signal MDQ-, respectively. A vertical direction represents instantaneous signal level. Each mixer driver signal has an instantaneous signal level that may correspond with a high value H or a low value L. The common horizontal axis, which represents time T, indicates various different instants t1, ..., t15 that are equidistantly spaced.

In the non-inverting in-phase mixer driver signal MDI+, pulses periodically occur with a period P. The non-inverting in-phase mixer driver signal MDI+ has the high value H during a pulse and has the low value L otherwise. Each pulse has a width that is substantially equal to one quarter of the period P. That is, each pulse is approximately ¼P wide. Consequently, the in-phase mixer driver signal corresponds with a square wave signal that has a duty cycle of approximately 25%. The non-inverting in-phase mixer driver signal MDI+ has a fundamental frequency that is equal to the inverse of the period P. The aforementioned also applies to the other three mixer driver signals: the inverting in-phase mixer driver signal MDI-, the non-inverting quadrature mixer driver signal MDQ+, and the inverting quadrature mixer driver signal MDQ-.

There is no overlap between the respective pulses in the respective mixer driver signals. That is, at any given instant, only a single mixer driver signal has the high value H. The other three mixer driver signals have the low value L at that given instant. For example, the non-inverting in-phase mixer driver signal MDI+ has the high value H during a time interval "t1-t2" between instant t1 and instant t2, which is ¼P wide. The other three mixer driver signals MDI-, MDQ+, MDQ- have the low value L during that time interval t1-t2. The non-inverting quadrature mixer driver signal MDQ+ has the high value H during a subsequent time interval "t2-t3" between instant t2 and instant t3, which is also ¼P wide. The other three mixer driver signals MDI+, MDI-, MDQ- have the low value L during that time interval t2-t3.

The mixer driver signals MDI+, MDI-, MDQ+, MDQ- have a particular phase relationship with respect to each other. The non-inverting quadrature mixer driver signal MDQ+ has a 90° phase lag with respect to the non-inverting in-phase mixer driver signal MDI+. The 90° phase lag corresponds with a time shift of ¼P: a pulse in the non-inverting in-phase mixer driver signal MDI+ is followed by a pulse in the non-inverting quadrature mixer driver signal MDQ+, which occurs ¼P later. The inverting in-phase mixer driver signal MDI- has a 180° phase lag with respect to the non-inverting in-phase mixer driver signal MDI+. The 180° phase lag corresponds with a time shift of ½P. The inverting quadrature mixer driver signal MDQ- has a 270° phase lag with respect to the non-inverting in-phase mixer driver signal MDI+. The 270° phase lag corresponds with a time shift of ¾P.

Referring again to Fig. 2, the four transistors M11, ..., M 14 in switch cell SWC1 operate as switches, each of which may be in a conductive state or a nonconductive state.. The same applies to the four transistors M21, ..., M24 in switch cell SWC2. Transistors M11, M14 are in the conductive state only when the non-inverting in-phase mixer driver signal MDI+ has the high value H. That is, transistors M11, M14 are in conductive state during a pulse in the non-inverting in-phase mixer driver signal MDI+, which occurs between instants t1 and t2, between instants t5 and t6, between instants t9 and t10, and between instants t13 and t 14, as illustrated in Fig. 3. Transimpedance stage TIS1 receives the differential signal current IS from the common transadmittance stage TAS in a non-inverted form during these respective intervals of time.

Transistors M12, M13 are in the conductive state only when the inverting in-phase mixer driver signal MDI- has the high value H. That is, transistors M12, M13 are in conductive state during a pulse in the inverting in-phase mixer driver signal MDI-, which occurs between instants t3 and t4, between instants t7 and t8, and between instants t11 and t12, as illustrated in Fig. 3. Transimpedance stage TIS1 receives the differential signal current IS from the transadmittance stage TAS in an inverted form during these respective intervals of time.

Transistors M21, M24 are in the conductive state only when the non-inverting quadrature mixer driver signal MDQ+ has the high value H. That is, transistors M21, M24 are in conductive state during a pulse in the non-inverting quadrature mixer driver signal MDQ+, which occurs between instants t2 and t3, between instants t6 and t7, and between instants t10 and t11, as illustrated in Fig. 3. Transimpedance stage TIS2 receives the differential signal current IS from the common transadmittance stage TAS in a non-inverted form during these respective intervals of time.

Transistors M22, M23 are in the conductive state only when the inverting quadrature mixer driver signal MDQ- has the high value H. That is, transistors M22, M23 are in conductive state during a pulse in the inverting quadrature mixer driver signal MDQ-, which occurs between instants t4 and t5, between instants t8 and t9, and between instants t12 and t13, as illustrated in Fig. 3. Transimpedance stage TIS2 receives the differential signal current IS from the common transadmittance stage TAS in an inverted form during these respective intervals of time.

The in-phase mixer driver signals cause switch cell SWC1 to transfer the differential signal current IS from the common transadmittance stage TAS to transimpedance stage TIS1 in a non-inverted form between instants t1 and t2 and in an inverted form between instants t3 and t4. The pair of in-phase mixer driver signals MDI+, MDI- prevent switch cell SWC1 from transferring the differential signal current IS from the common transadmittance stage TAS to transimpedance stage TIS1 between instants t2 and t3 and between instants t4 and t5. Accordingly, transimpedance stage TIS1 receives an input signal that corresponds with the differential signal current IS multiplied by an effective in-phase oscillator signal, which comprises positive pulses and negative pulses. The positive pulses correspond with the pulses in the non-inverting in-phase mixer driver signal MDI+. The negative pulses correspond with the pulses in the inverting in-phase mixer driver signal MDI-. The effective in-phase oscillator signal has a fundamental frequency component that corresponds with the fundamental frequency of the set of mixer driver signals MD.

The quadrature mixer driver signals cause switch cell SWC2 to transfer the differential signal current IS from the common transadmittance stage TAS to transimpedance stage TIS2 in a non-inverted form between instants t2 and t3 and in an inverted form between instants t4 and t5. The pair of quadrature mixer driver signals MDQ+, MDQ- prevent switch cell SWC2 from transferring the differential signal current IS from the common transadmittance stage TAS to transimpedance stage TIS2 between instants t1 and t2 and between instants t3 and t4. Accordingly, transimpedance stage TIS receives an input signal that corresponds with the differential signal current IS multiplied by an effective quadrature oscillator signal, which comprises positive pulses and negative pulses. The positive pulses correspond with the pulses in the non-inverting quadrature mixer driver signal MDQ+. The negative pulses correspond with the pulses in the inverting quadrature mixer driver signal MDQ-. The effective quadrature oscillator signal has a fundamental frequency component that corresponds with a 90° phase shifted version of the fundamental frequency component in the effective in-phase oscillator signal.

Importantly, a second harmonic frequency component will substantially not occur on the joint common switch node CN 1 for transistors M11, M 12 in the in-phase mixer and for transistors M21, M22 in the quadrature mixer. The reason for this is that this joint common switch node CN1 experiences, as it were, each of the four mixer driver signals MDI+, MDI-, MDQ+, MDQ- illustrated in Fig. 3. That is, the joint common switch node CN 1 experiences four pulses during the period P, which defines the fundamental frequency. A fourth harmonic frequency component may therefore occur on the joint common switch node CN1, instead of a second harmonic frequency component, which typically occurs on the common switch node of a switch pair in a conventional mixer. For similar reasons, a second harmonic frequency component will substantially not occur on the joint common switch node CN2 for transistors M13, M14 in the in-phase mixer and for transistors M23, M24 in the quadrature mixer. Since a second harmonic frequency component does not substantially occur on the joint common switch nodes CN1, CN2, the dual mixer MIX illustrated in Fig. 2 has a relatively high second-order input-referred intercept point.

It is also worthwhile to highlight the following aspect. Switch cell SWC1 does not, at any given instant, create a short circuit between the non-inverting input "+"and the inverting input "-" of transimpedance stage TIS1. Such a short circuit would otherwise severely deteriorate the noise Figure of the dual mixer MIX. This is particularly true in case the dual mixer MIX is used in a direct conversion architecture and transimpedance stage TIS1 has field effect input transistors. Field effect transistors suffer from so-called 1/f noise, which is a low frequency noise. Transimpedance stage TIS1 will amplify the 1/f noise of the field effect input transistors to relatively large extent if there is a short circuit between the non-inverting input "+" and the inverting input "-". This is because, in that case, transimpedance stage TIS1 constitutes a relatively high-gain voltage amplifier, which amplifies the 1/f noise. The aforementioned also applies to transimpedance stage TIS2. Since the two switch cells SWC1, SWC2 do not create short circuits between the non-inverting inputs "+" and the inverting inputs "-" of the two transimpedance stages TIS 1, TIS2, the dual mixer MIX illustrated in Fig. 2 can have a relatively low noise Figure.

Fig. 4 illustrates the local oscillator LO, which provides the set of mixer driver signals MD illustrated in Fig. 3. The local oscillator LO comprises a double-frequency oscillator DFO, a frequency divider DIV, and a logic gate circuit LGC. The double-frequency oscillator DFO provides a pair of double-frequency oscillator signals: a non-inverted double-frequency oscillator signal DFC+ and an inverted double-frequency oscillator signal DFC-. The pair of double-frequency oscillator signals thus effectively constitutes a differential signal. The aforementioned double-frequency oscillator signals have a frequency that is twice the fundamental frequency of the set of mixer driver signals MD illustrated in Fig. 3.

The frequency divider DIV, which receives the pair of double-frequency oscillator signals, carries out a frequency division by two. The frequency division by two produces a pair of in-phase oscillator signals: a non-inverted in-phase oscillator signal IC+ and an inverted in-phase oscillator signal IC-. The frequency division by two further produces a pair of quadrature oscillator signals: a non-inverted quadrature oscillator signal QC+, and an inverted quadrature oscillator signal QC-. Each of the aforementioned oscillator signals IC+, IC-, QC+, QC-, which the frequency divider DIV provides, effectively constitutes a square wave signal that has a 50% duty cycle.

The logic gate circuit LGC applies logic "and" functions to respective combinations of the oscillator signals IC+, IC-, QC+, QC-, so as to obtain the set of mixer driver signals MD illustrated in Fig. 3. For example, applying a logic "and" function to the non-inverted in-phase oscillator signal IC+ and the inverted quadrature oscillator signal QC-produces the non-inverting in-phase mixer driver signal MDI+. As another example, applying a logic "and" function to the non-inverted in-phase oscillator signal IC+ and the non-inverted quadrature oscillator signal QC+ produces the non-inverting quadrature mixer driver signal MDQ+. The logic gate circuit LGC is preferably arranged such that the logic "and" functions have a substantially symmetrical character. This allows transitions from the high value H to the low value L, on the one hand, and transitions from the low value L to the high-level, on the other hand, that are substantially symmetrical, which contributes to a good performance of the dual mixer MIX illustrated in Fig. 2.

### CONCLUDING REMARKS

The detailed description hereinbefore with reference to the drawings is merely an illustration of the invention and the additional features, which are defined in the claims. The invention can be implemented in numerous different manners. In order to illustrate this, some alternatives are briefly indicated.

The invention may be applied to advantage in any type of product that processes signals and any type of method of signal processing, which involves a frequency conversion. A communication apparatus is merely an example. The invention may equally be applied in, for example, a home entertainment apparatus or a measurement apparatus. What is more, a signal that is processed in accordance with the invention may represent any type of information. Audio information and graphical information are merely examples.

There are numerous different manners to implement a frequency converter in accordance with the invention. The frequency converter illustrated in Fig. 2 is of the quadrature type. This frequency converter comprises two mixers. The respective mixer driver signals have a N·90° phase relationship with respect to each other, N being an integer. This is merely an example. As another example, a frequency converter in accordance with the invention may comprise three mixers, which share a common switch node. The respective mixer driver signals may have a N· 60° phase relationship with respect to each other. In that case, a sixth harmonic frequency component would occur on the common switch node. The respective mixer driver signals, which have a N· 60° phase relationship with respect to each other, preferably comprises pulses which are ¹/₆ P wide and which do not substantially overlap which each other.

The frequency converter illustrated in Fig. 2 has a differential structure and, therefore, comprises double switch pairs. This is merely an example. A frequency converter in accordance with the invention may have single-ended structure. For example, the dual mixer MIX illustrated in Fig. 2 can be modified as follows. Transistors M13, M14 in switch cell SWC1 are omitted. Similarly, transistors M23, M24 in switch cell SWC2 are omitted. The common transadmittance stage TAS is modified so that the stage provides a single-ended signal current. It should further be noted that bipolar transistors may be used as switches within a mixer instead of field-effect transistors. It should also be noted that switches within a mixer may receive a signal voltage instead of a signal current. In such a variant, a voltage amplifier may constitute the input circuit, instead of a transadmittance stage.

There are numerous different manners to generate suitable mixer driver signals. The local oscillator LO illustrated in Fig. 4 is merely an example. As another example, the local oscillator may comprise a quadruple frequency oscillator that provides a quadruple frequency oscillator signal, which has a frequency that is four times the fundamental frequency of the mixer driver signals. One or more frequency dividers may generate the set of mixer driver signals on the basis of the quadruple frequency oscillator signal. In this respect, it should be noted that a finite state machine that generates one output pulse for four input pulses may constitute a frequency divider. Respective finite state machines may be desynchronized, as it were, so as to provide appropriate phase relationships (0°, 90°, 180°, 270°). As yet another example, a so-called ring oscillator, which oscillates at the aforementioned fundamental frequency, may provide such an appropriate phase relationship, which allows generating the set of mixer driver signals.

There are numerous ways of implementing functions by means of items of hardware or software, or both. In this respect, the drawings are very diagrammatic, each representing only one possible embodiment of the invention. Thus, although a drawing shows different functions as different blocks, this by no means excludes that a single item of hardware or software carries out several functions. Nor does it exclude that an assembly of items of hardware or software or both carry out a function.

The remarks made herein before demonstrate that the detailed description with reference to the drawings, illustrate rather than limit the invention. There are numerous alternatives, which fall within the scope of the appended claims. Any reference sign in a claim should not be construed as limiting the claim. The word "comprising" does not exclude the presence of other elements or steps than those listed in a claim. The word "a" or "an" preceding an element or step does not exclude the presence of a plurality of such elements or steps.

## Claims

1. A signal processor (RFP, MIX, LO, FA1, FA2, BEP) that includes a frequency converter (MIX, LO) comprising:
- a dual mixer (MIX) comprising a first phase mixer (SWC1, TIS1) having a pair of switches (M11, M12) with a common switch node; the first phase mixer providing an in-phase intermediate frequency signal (IF1); and a second phase mixer (SWC2, TIS2) having a pair of switches (M21, M22) with a common switch node, the second phase mixer providing a quadrature intermediate frequency signal (IFQ); wherein the common switch node of the pair of switches in the first phase mixer corresponds with the common switch node of the pair of switches in the second phase mixer so that the pair of switches in the first phase mixer and the pair of switches in the second phase mixer have a joint common switch node (CN1); and
- a local oscillator (LO) arranged to generate an individual mixer driver signal (MDI+, MDI-, MDQ+, MDQ-) for each switch (M11, M12, M21, M22) in the aforementioned pairs, each individual mixer driver signal comprising periodically occurring pulses, which are phase shifted with respect to the periodically occurring pulses in the other individual mixer driver signals.

2. A signal processor according to claim 1, the local oscillator (LO) being arranged to generate the individual mixer driver signals (MDI+, MDI-, MDQ+, MDQ-) so that there is substantially no overlap between the periodically occurring pulses in the individual mixer driver signals.

3. A signal processor according to claim 1, the local oscillator (LO) being arranged to generate the individual mixer driver signals (MDI+, MDI-, MDQ+, MDQ-) so that each individual mixer driver signal has a duty cycle that is substantially 25%.

4. A signal processor according to claim 1, wherein:
- the first phase mixer (SWC1, TIS1) comprises a further pair of switches (M 13, M 14) with a common switch node; and
- the second phase mixer (SWC2, TIS2) comprises a further pair of switches (M23, M24) with a common switch node; the common switch node of the further pair of switches in the first phase mixer corresponding with the common switch node of the further pair of switches in the second phase mixer so that the further pair of switches in the first phase mixer and the further pair of switches in the second phase mixer have a joint common switch node (CN2).

5. A signal processor according to claim 1, the switches (M11, M12, M21, M22) being in the form of field effect transistors.

6. A signal processor according to claim 1, comprising a common input stage (TAS) for applying a signal current (IS) to the joint common switch node (CN1).

7. A signal processor according to claim 1, the local oscillator (LO) comprising:
- a double-frequency oscillator (DFO) for providing a double-frequency oscillator signal (DFC+, DFC-);
- a frequency divider (DIV) for providing an in-phase oscillator signal (IC+, IC-) and a quadrature oscillator signal (QC+, QC-) on the basis of the double-frequency oscillator signal (DFC+, DFC-); and
- a logic gate circuit LGC for generating the individual mixer driver signals on the basis of the in-phase oscillator signal and the quadrature oscillator signal.

8. A communication apparatus (CAP) comprising a signal processor (RFP, MIX, LO, FA1, FA2, BEP) according to claim 1 coupled between a radiofrequency interface (ANT) and a human-interface device (DPL).

## Patentansprüche

1. Signalprozessor (RFP, MIX, LO, FA1, FA2, BEP), der einen Frequenzwandler (MIX, LO) enthält, umfassend:
- einen Dualmischer (MIX), umfassend einen ersten Phasenmischer (SWC1, TIS1) mit einem Paar von Schaltern (M11, M12) mit einem gemeinsamen Schaltknoten; wobei der erste Phasenmischer ein phasengleiches Zwischenfrequenzsignal (IFI) bereitstellt, und einen zweiten Phasenmischer (SWC2, TIS2) mit einem Paar von Schaltern (M21, M22) mit einem gemeinsamen Schaltknoten; wobei der zweite Phasenmischer ein Quadraturzwischenfrequenzsignal (IFQ) bereitstellt; wobei der gemeinsame Schaltknoten des Paares von Schaltern im ersten Phasenmischer dem gemeinsamen Schaltknoten des Paares von Schaltern im zweiten Phasenmischer entspricht, so dass das Paar von Schaltern im ersten Phasenmischer und das Paar von Schaltern im zweiten Phasenmischer einen verbundenen gemeinsamen Schaltknoten (CN1) haben; und
- einen lokalen Oszillator, der zum Erzeugen eines individuellen Mischertreibersignals (MDI+, MDI-, MDQ+, MDQ-) für jeden Schalter (M11, M12, M21, M22) in den oben genannten Paaren angeordnet ist, wobei jedes individuelle Mischertreibersignal periodisch auftretende Impulse umfasst, die in Bezug auf die periodisch auftretenden Impulse in den anderen individuellen Mischertreibersignalen phasenverschoben sind.

2. Signalprozessor nach Anspruch 1, wobei der lokale Oszillator (LO) so angeordnet ist, dass er die individuellen Mischertreibersignale (MDI+, MDI-, MDQ+, MDQ-) so erzeugt, dass es im Wesentlichen keine Überlappung zwischen den periodisch auftretenden Impulsen in den individuellen Mischertreibersignalen gibt.

3. Signalprozessor nach Anspruch 1, wobei der lokale Oszillator (LO) so angeordnet ist, dass er die individuellen Mischertreibersignale (MDI+, MDI-, MDQ+, MDQ-) so erzeugt, dass jedes individuelle Mischertreibersignal einen Arbeitszyklus hat, der im Wesentlichen 25% ist.

4. Signalprozessor nach Anspruch 1, wobei
- der erste Phasenmischer (SWC1, TIS1) ein weiteres Paar von Schaltern (M13, M14) mit einem gemeinsamen Schaltknoten umfasst; und
- der zweite Phasenmischer (SWC2, TIS2) ein weiteres Paar von Schaltern (M23, M24) mit einem gemeinsamen Schaltknoten umfasst; wobei der gemeinsame Schaltknoten des weiteren Paares von Schaltern im ersten Phasenmischer dem gemeinsamen Schaltknoten des weiteren Paares von Schaltern im zweiten Phasenmischer entspricht, so dass das weitere Paar von Schaltern im ersten Phasenmischer und das weitere Paar von Schaltern im zweiten Phasenmischer einen verbundenen gemeinsamen Schaltknoten (CN2) haben.

5. Signalprozessor nach Anspruch 1, wobei die Schalter (M11, M12, M21, M22) die Form von Feldeffekttransistoren haben.

6. Signalprozessor nach Anspruch 1, umfassend eine gemeinsame Eingabestufe (TAS) zum Anlegen eines Signalstroms (IS) an den verbundenen gemeinsamen Schaltknoten (CN1).

7. Signalprozessor nach Anspruch 1, wobei der lokale Oszillator (LO) umfasst:
- einen Doppelfrequenzoszillator (DFO) zum Bereitstellen eines Doppelfrequenzoszillatorsignals (DFC+, DFC-);
- einen Frequenzteiler (DIV) zum Bereitstellen eines phasengleichen Oszillatorsignals (IC+, IC-) und eines Quadraturoszillatorsignals (QC+, QC-) auf der Basis des Doppelfrequenzoszillatorsignals (DFC+, DFC-); und
- einen logischen Gate-Schaltkreis LGC zum Erzeugen der individuellen Mischertreibersignale auf der Basis des phasengleichen Oszillatorsignals und des Quadraturoszillatorsignals.

8. Kommunikationsvorrichtung (CAP), umfassend einen Signalprozessor (RFP, MIX, LO, FA1, FA2, BEP) nach Anspruch 1, der zwischen einer Hochfrequenzschnittstelle (ANT) und einer Benutzerschnittstellenvorrichtung (DPL) gekoppelt ist.

## Revendications

1. Processeur de signal (RFP, MIX, LO, FA1, FA2, BEP) qui inclut un convertisseur de fréquence (MIX, LO) comprenant :
- un mélangeur double (MIX) comprenant un premier mélangeur de phase (SWC1, TIS1) ayant un couple de commutateurs (M11, M12) avec un noeud de commutateur commun ; le premier mélangeur de phase fournissant un signal de fréquence intermédiaire en phase (IFI) ; et un second mélangeur de phase (SWC2, TIS2) ayant un couple de commutateurs (M21, M22) avec un noeud de commutateur commun, le second mélangeur de phase fournissant un signal de fréquence intermédiaire en quadrature (IFQ) ; dans lequel le noeud de commutateur commun du couple de commutateurs dans le premier mélangeur de phase correspond au noeud de commutateur commun du couple de commutateurs dans le second mélangeur de phase de sorte que le couple de commutateurs dans le premier mélangeur de phase et le couple de commutateurs dans le second mélangeur de phase ont un noeud de commutateur commun conjoint (CNI) ; et
un oscillateur local (LO) agencé pour produire un signal de gestionnaire de mélangeur individuel (MDI+, MDI-, MDQ+, MDQ-) pour chaque commutateur (M11, M12, M21, M22) dans les couples précédemment mentionnés, chaque signal de gestionnaire de mélangeur individuel comprenant des impulsions se produisant de façon périodique, qui sont déphasées par rapport aux impulsions se produisant de façon périodique dans les autres signaux de gestionnaire de mélangeur individuel.

2. Processeur de signal selon la revendication 1, l'oscillateur local (LO) étant agencé pour produire les signaux de gestionnaire de mélangeur individuel (MDI+, MDI-, MDQ+, MDQ-) de sorte qu'il n'y a sensiblement aucun chevauchement entre les impulsions se produisant de façon périodique dans les signaux de gestionnaire de mélangeur individuel.

3. Processeur de signal selon la revendication 1, l'oscillateur local (LO) étant agencé pour produire les signaux de gestionnaire de mélangeur individuel (MDI+, MDI-, MDQ+, MDQ-) de sorte que chaque signal de gestionnaire de mélangeur individuel a un rapport cyclique qui est sensiblement de 25 %.

4. Processeur de signal selon la revendication 1, dans lequel :
le premier mélangeur de phase (SWC1, TIS1) comprend un couple supplémentaire de commutateurs (M13, M14) avec un noeud de commutateur commun ; et
- le second mélangeur de phase (SWC2, TIS2) comprend un couple supplémentaire de commutateurs (M23, M24) avec un noeud de commutateur commun ; le noeud de commutateur commun du couple supplémentaire de commutateurs dans le premier mélangeur de phase correspondant au noeud de commutateur commun du couple supplémentaire de commutateurs dans le second mélangeur de phase de sorte que le couple supplémentaire de commutateurs dans le premier mélangeur de phase et le couple supplémentaire de commutateurs dans le second mélangeur de phase ont un noeud de commutateur commun conjoint (CN2).

5. Processeur de signal selon la revendication 1, les commutateurs (M11, M12, M21, M22) étant sous la forme de transistors à effet de champ.

6. Processeur de signal selon la revendication 1, comprenant un étage d'entrée commun (TAS) pour appliquer un courant de signal (IS) au noeud de commutateur commun conjoint (CN1).

7. Processeur de signal selon la revendication 1, l'oscillateur local (LO) comprenant :
- un oscillateur à fréquence double (DFO) pour fournir un signal d'oscillateur de fréquence double (DFC+, DFC-) ;
- un séparateur de fréquence (DIV) pour fournir un signal d'oscillateur en phase (IC+, IC-) et un signal d'oscillateur en quadrature (QC+, QC-) sur la base du signal d'oscillateur de fréquence double (DFC+, DFC-) ; et
- une circuit à porte logique LGC pour produire les signaux de gestionnaire de mélangeur individuel sur la base du signal d'oscillateur en phase et du signal d'oscillateur en quadrature.

8. Appareil de communication (CAP) comprenant un processeur de signal (RFP, MIX, LO, FA1, FA2, BEP) selon la revendication 1, couplé entre une interface de radiofréquence (ANT) et un dispositif à interface humaine (DPL).
